# EUROPEAN PATENT APPLICATION

(11) **EP 4 808 343 A1**
(43) Date of publication of application: **16.09.2026**
(21) Application number: 25225211.9
(22) Date of filing: 18.12.2025
(51) Int. Cl.: H10W 90/26, H10W 90/20, H10W 90/00

(54) **PACKAGE HAVING A MEMORY STACK AND HEAT-TRANSFER LAYERS ABOVE A BASE DIE**

(30) Priority: 10.03.2025 US 202519075602
(71) Applicant: Intel Corporation, Santa Clara, CA 95054 (US)
(72) Inventor: SHARMA, Abhishek Anil, Portland, 97229 (US); IYER, Anand V., Saratoga, 95070 (US); MAJHI, Prashant, Santa Clara, 95054 (US); DESHPANDE, Nitin A., Chandler, 85286 (US); MOSTAFAVI, Amirhossein, Phoenix, 85021 (US); VISWANATH, Ram S., Phoenix, 85045 (US)
(74) Representative: 2SPL Patentanwälte PartG mbB

(57) **Abstract**

Technologies for thermal management of the base die in high-bandwidth memory (HBM) die stacks are disclosed. In an illustrative embodiment, the interface logic region of the base die is a hot spot, as all of the high-speed signals into and out of the HBM die stack pass through the interface logic region. The memory dies stacked above the base die may not extend all the way across the HBM die stack, leaving space above the interface logic region of the base die. A stack of one or more heat transfer layers can be deposited on the base die above the interface logic region, removing heat and conducting it up to the top of the HBM die stack, where a heat sink or integrated heat spreader may be. The stack of one or more heat transfer layers may be any suitable material, such as silicon, dielectric packaging mold, etc.

## Description

### BACKGROUND

High-bandwidth memory (HBM) is an advanced memory technology designed to provide significantly higher data transfer rates and power efficiency compared to conventional DRAM solutions. HBM systems achieve this by vertically stacking multiple memory dies and connecting the dies using through-silicon vias (TSVs), which provide dense, low-latency communication pathways to a nearby processor. These stacks are then mounted onto a silicon interposer or an embedded bridge, allowing for wide parallel data buses between the memory and the processor.

HBM offers several key advantages over traditional memory architectures. Its high bandwidth per watt makes it particularly well-suited for applications requiring massive data throughput, such as artificial intelligence (AI), machine learning (ML), high-performance computing (HPC), and graphics processing. Additionally, its compact form factor reduces the overall footprint on a package, enabling more efficient use of space in tightly integrated systems. By keeping memory closer to the processor and minimizing the distance data must travel, HBM significantly reduces latency and improves energy efficiency.

The capacity of HBM can be increased by stacking more memory dies. However, stacking more memory dies can lead to several challenges, such as a larger difference in signal path from different memory dies and an increased heat load, particularly at the interface with the interposer or bridge die.

### BRIEF DESCRIPTION OF THE DRAWINGS

FIG. 1 is an isometric view of one embodiment of a system with a processor and several high-bandwidth memory (HBM) stacks on a circuit board.
FIG. 2 is a cross-sectional view of one embodiment of the system of FIG. 1.
FIG. 3 is a cross-sectional view of one embodiment of an HBM stack of FIG. 1.
FIG. 4 is a cross-sectional view of one embodiment of an HBM stack of FIG. 1.
FIG. 5 is a cross-sectional view of one embodiment of an HBM stack of FIG. 1.
FIG. 6 is a cross-sectional view of one embodiment of an HBM stack of FIG. 1.
FIG. 7 is a flowchart of one embodiment of a method of creating one embodiment of the system of FIG. 1.
FIG. 8 is a cross-sectional view of one embodiment of an HBM die stack at one stage of the flowchart of FIG. 7.
FIG. 9 is a cross-sectional view of one embodiment of an HBM die stack at one stage of the flowchart of FIG. 7.
FIG. 10 is a cross-sectional view of one embodiment of an HBM die stack at one stage of the flowchart of FIG. 7.
FIG. 11 is a cross-sectional view of one embodiment of an HBM die stack at one stage of the flowchart of FIG. 7.
FIG. 12 is a top view of a wafer and dies that may be included in a microelectronic assembly, in accordance with any of the embodiments disclosed herein.
FIG. 13 is a cross-sectional side view of an integrated circuit device that may be included in a microelectronic assembly, in accordance with any of the embodiments disclosed herein.
FIGS.14A-14D are perspective views of example planar, gate-all-around, and stacked gate-all-around transistors.
FIG. 15 is a cross-sectional side view of an integrated circuit device assembly that may include a microelectronic assembly, in accordance with any of the embodiments disclosed herein.
FIG. 16 is a block diagram of an example electrical device that may include a microelectronic assembly, in accordance with any of the embodiments disclosed herein.

### DETAILED DESCRIPTION

In various embodiments disclosed herein, an integrated circuit component has a circuit board with several high-bandwidth memory HBM die stacks and a processor disposed on its surface. Each HBM die stack includes a base die (or interface die) and several memory dies. In an illustrative embodiment, the memory dies do not extend the full width of the base die. In particular, the memory dies do not extend over the region with interface logic, which is the component of the base die that dissipates energy at the highest density. In order to more effectively remove heat, a stack of one or more heat transfer layers is positioned on top of the base die. The stack of one or more heat transfer layers extends to the top of the HBM die stack, allowing heat to be effectively transferred to the top of the HBM die stack and removed by a heat sink or integrated heat spreader.

As used herein, the phrase "communicatively coupled" refers to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate and an integrated circuit component attached to a printed circuit board that send signals to or receives signals from other integrated circuit components or electronic devices attached to the printed circuit board.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact, and "coupled" may indicate elements co-operate or interact, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, the central axis of a magnetic plug that is substantially coaxially aligned with a through hole may be misaligned from a central axis of the through hole by several degrees. In another example, a substrate assembly feature, such as a through width, that is described as having substantially a listed dimension can vary within a few percent of the listed dimension.

It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons.

Reference is now made to the drawings, which are not necessarily drawn to scale, wherein similar or same numbers may be used to designate the same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

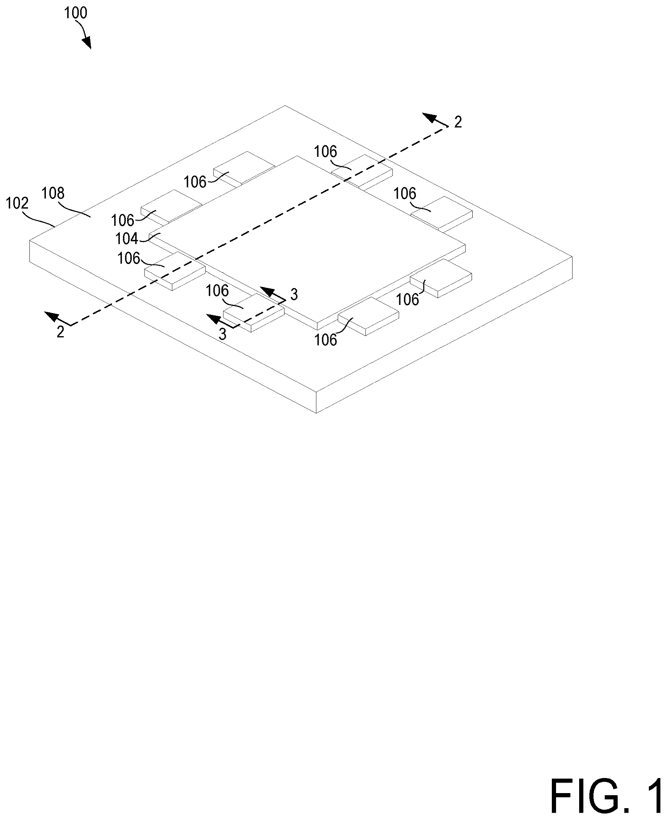

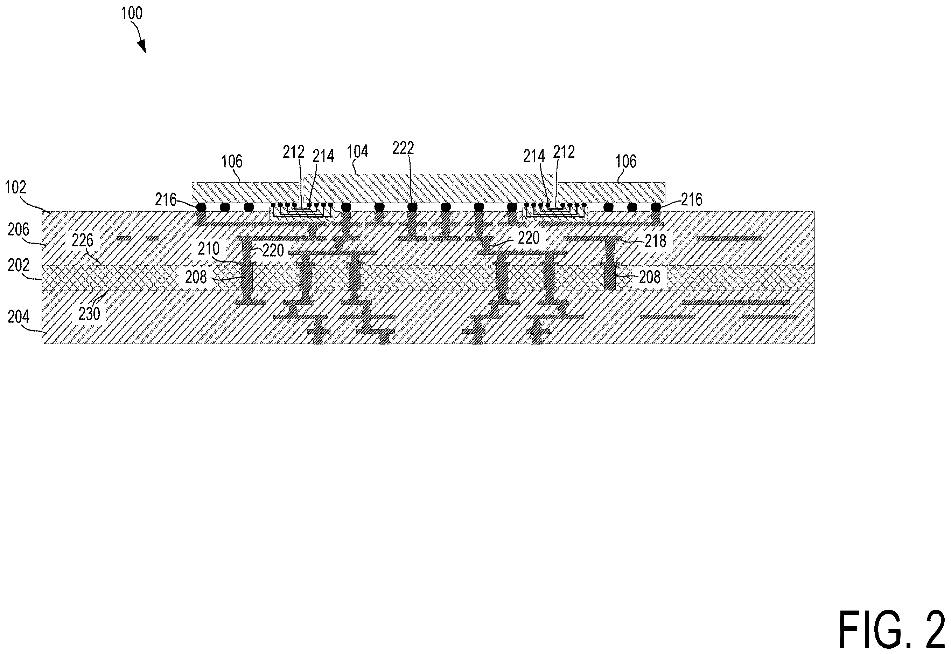

Referring now to FIGS. 1 and 2, in one embodiment, an integrated circuit component 100 includes a circuit board 102 on which one or more dies 104 are mounted. FIG. 1 shows an isometric view of the integrated circuit component 100, and FIG. 2 shows a cross-sectional view of the integrated circuit component 100. As shown in FIG. 1, a die 104 such as a processor die 104 may be disposed on the top surface 108 of the circuit board 102. In an illustrative embodiment, additional components, such as HBM die stacks 106, are disposed on the top surface 108 of the circuit board 102 as well, spread out around the processor die 104.

It should be appreciated that, as used herein, the "top side," "bottom side," etc., is an arbitrary designation used for clarity and does not denote a particular required orientation for manufacture or use. Although the illustrative embodiment described has the dies 104 and/or dies of the stack 106 placed on the "top" side of the circuit board 102, in some embodiments, those components may be placed on the "bottom" side of the circuit board 102.

In an illustrative embodiment, the die 104 is a processor die, and the processor die 104 is surrounded by one or more HBM die stacks 106. In other embodiments, the die 104 and/or the dies of the stack 106 may be any suitable die or stack of dies, such as one or more processor dies, memory dies, central processing units (CPUs), graphics processing units (CPUs), any other suitable processing units (xPUs), accelerator circuits, a field-programmable gate arrays (FPGA), application-specific integrated circuits (ASICs), etc. The dies 104 and/or dies of the stack 106 may be connected to contact pads or vias 220 on the circuit board 102 through conductive contacts 222, such as solder balls. In an illustrative embodiment, a bridge die 212 connects each HBM die stack 106 to the processor die 104.

In an illustrative embodiment, the HBM die stacks 106 are a specialized type of dynamic random-access memory (DRAM) designed to deliver significantly higher memory bandwidth while maintaining low power consumption compared to traditional memory technologies like double data rate (DDR) or graphics double data rate (GDDR) DRAM. HBM die stacks 106 achieve this through vertically stacked architecture and a wide interface with the processor, reducing the clock speed requirement and power consumption while providing massive bandwidth. Use of a bridge die 212 allows for high-density, high-bandwidth channels between the HBM die stacks 106 and the processor die 104.

In an illustrative embodiment, the HBM die stacks 106 are compatible with various standards, such as a Universal Chiplet Interface express (UCIe). For example, the HBM die stacks 106 and the communication to and from the HBM die stacks 106 may be compatible with UCIe 1.0, UCIe 1.1, UCIe 2.0., etc. In some embodiments, different protocols or standards may be used, such as Joint Electron Device Engineering Council (JEDEC) HBM (JESD235), HBM2 (JESD235A), HBM2E (JESD235B), HBM3 (JESD238), HBM3 Update (JESD238A), HBM4, Compute Express Link (CXL) 1.0, CXL 2.0, CXL 3.0, CXL 3.1, CXL 3.2, Peripheral Component Interconnect express (PCIE) 3.0, PCIe 4.0, PCIe 5.0, PCIe 6.0, etc.

Each HBM die stack 106 may have any suitable storage capacity and/or bandwidth, such as 4-128 GB capacity and/or 128-1,600 GB/s.

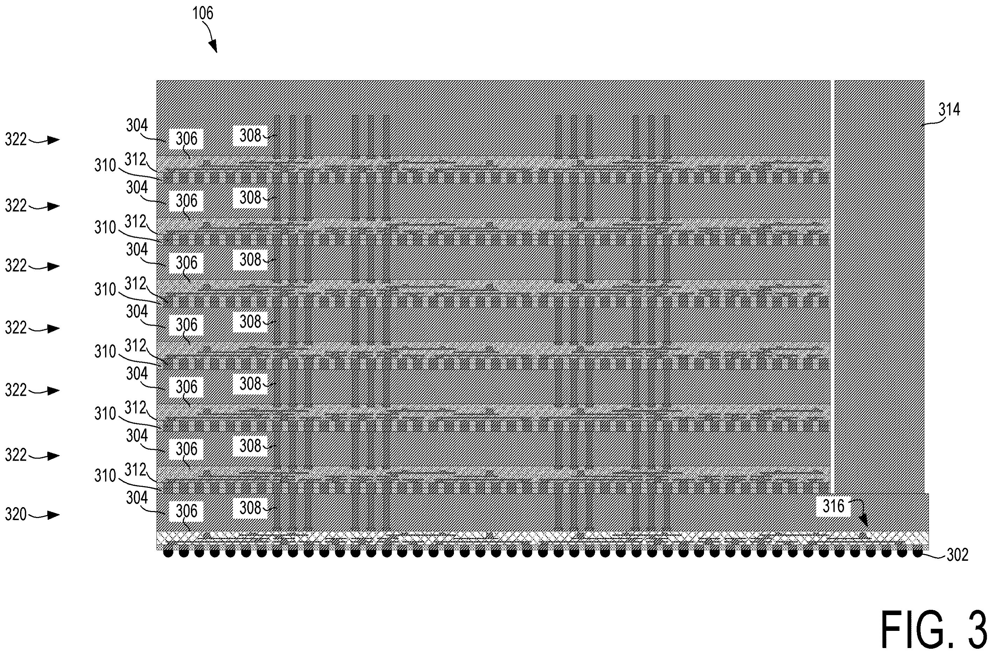

In an illustrative embodiment, each HBM die stack 106 is coupled to the processor die 104 though a bridge die 212. In other embodiments, a silicon interposer may be used, with some or all of the HBM die stack 106 and the processor die 104 mounted on the interposer. In an illustrative embodiment, the bridge die 212 is silicon-based. In other embodiments, the bridge die 212 can be embodied as an organic substrate. The bridge die 212 may be embodied as, e.g., an embedded multi-die interconnect bridge (EMIB). The number of dies in an HBM die stack 106 can vary depending on the application, ranging from a single stack for lower-end devices to 4, 6, or 8 or more stacks for high-performance GPUs and AI accelerators. The HBM die stack 106 is described in more detail below in regard to FIG. 3. As shown in the figure, in an illustrative embodiment, the bridge die 212 is counter-sunk into the circuit board 102.

In an illustrative embodiment, the bridge die 212 is a passive component made of silicon that routes signals between the HBM die stack 106 and the processor die 104. In some embodiments, the bridge die 212 may be an active bridge die, incorporating features such as buffering, signal conditioning, or even computational logic to reduce latency and improve signal integrity. The processor die 104 interfaces with the HBM die stack 106 via a memory controller that implements HBM-specific protocols like HBM2 or HBM3 PHY or other protocols described herein. Data packets may be transferred using burst-mode operations to maximize throughput while minimizing overhead.

In an illustrative embodiment, the HBM die stack 106 and the processor die 104 are coupled to the bridge die 212 using microbumps 214, which may have a pitch of, e.g., 14-50 micrometers. Additionally or alternatively, the HBM die stack 106 and/or the processor die 104 may be coupled to the circuit board 102 using larger solder bumps, such as bumps with a pitch of 40-500 micrometers.

The circuit board 102 includes a substrate core 202, lower build-up layers 204, and upper build-up layers 206. Holes or cavities are defined in the substrate core 202 that extend from the top surface 226 of the substrate core 202 to the bottom surface 230 of the substrate core 202. Vias 208 are disposed in the hole, and pads 210 may be positioned at one or both ends of the vias 208.

In an illustrative embodiment, the circuit board 102 is a multi-layer circuit board 102 with build-up layers 204, 206 above and below the substrate core 202. The build-up layers 204, 206 may have any suitable number of layers, such as 1-10 layers each. In other embodiments, the circuit board 102 may be a single-layer circuit board 102. In an illustrative embodiment, the substrate core 202 is an inorganic core, such as a glass core. The glass core may be silicon oxide glass. In other embodiments, the glass core may be made of any suitable material that may be crystalline, non-crystalline, amorphous, etc., such as fused silicon, borosilicate, sapphire, yttrium aluminum garnet, etc. The glass core may be, e.g., aluminosilicate glass, borosilicate glass, alumino-borosilicate glass, silica, fused silica. The glass core may include one or more additives, such as Al2O3, B2O3, MgO, CaO, SrO, BaO, SnO2, Na2O, K2O, SrO, P2O3, ZrO2, Li2O, Ti, and Zn. The glass core may comprise silicon and oxygen, as well as any one or more of aluminum, boron, magnesium, calcium, barium, tin, sodium, potassium, strontium, phosphorus, zirconium, lithium, titanium, and zinc. The glass core may include at least 20-40 percent silicon by weight, at least 20-40 percent oxygen by weight, and at least 5 percent aluminum by weight. For example, some embodiments of the glass core may include, e.g., at least 20-23 percent silicon and at least 20-26 percent oxygen by weight. In other embodiments, the substrate core 202 may be an organic core, such as a fiberglass board made of glass fibers and a resin, such as FR-4.

The thickness of the circuit board 102 may be any suitable thickness, such as 100 micrometers to 5 millimeters. The thickness of the substrate core 202 may be any suitable thickness, such as 50 micrometers to 2 millimeters. The circuit board 102 can have any suitable length and width, such as 1-500 millimeters. Although shown as a rectangle, it should be appreciated that the circuit board 102 may be any suitable shape and may have protrusions, cutouts, etc., in order to accommodate, fit, or touch other components of a device. In the illustrative embodiment, the circuit board 102 is planar. In other embodiments, the circuit board 102 may be non-planar.

The build-up layers 204, 206 may be made of any suitable material or materials, such as any suitable dielectric that can support the traces 218, vias 220, etc. In an illustrative embodiment, the build-up layers 204, 206 may be made of a resin material filled with a filler, such as Ajinomoto build-up film (ABF).

Referring now to FIG. 3, one embodiment of an HBM die stack 106 includes multiple memory dies 322 and a base die 320 vertically aligned and interconnected using copper-filled through-silicon vias (TSVs) 308 and pads 312. In an illustrative embodiment, the pads 312 of each memory die 322 and base die 320 are hybrid bonded to each other, with a dielectric filler 310 between the pads 312. Additionally or alternatively, other connections may be used, such as bump bonding.

Each HBM die stack 106 may include, e.g., 4, 8, or 16 memory dies 322. These dies may be referred to as memory layers, memory dies, or DRAM dies. The HBM die stack 106 also includes a base die 320. The base die 320 may be referred to as the base die, the interconnect die, the logic die, etc. The base die 320 is the logic die, which manages communication with the processor die 104 and data flow within the HBM die stack 106.

Each memory die 322 contains an array of memory cells arranged in banks, with each bank further subdivided into rows and columns for data access. The TSVs are etched through the silicon substrate 304 of each memory die 322, providing high-speed, low-latency connections between the dies. Several logic layers 306 are formed on the substrate 304 for control and data flow, DRAM storage, etc. The diameter of the TSVs may be any suitable value, such as 5-200 micrometers. The pitch for the pads 312 may be any suitable value, such as 10-50 micrometers.

The bottom of the HBM die stack 106 includes an array of microbumps 302. The pitch of the microbumps 302 may be any suitable value, such as 14-40 micrometers. The HBM die stack 106 may include any suitable number of microbumps 302 to connect with the bridge die 212, such as 1,024-4,096. In some embodiments, larger solder bumps 216 may be used to connect the HBM die stack 106 to the circuit board 102, such as for power delivery, lower data rate signals, etc.

The HBM die stack 106 communicates with the processor die 104 through a wide parallel interface of microbumps 302. These lines connect to the processor die 104 via the bridge die 212 or interposer, which routes signals from the microbumps 302 on the HBM die stack 106 microbumps or larger solder bumps on the processor die 104. The base die 320 includes interface logic 316 to implement protocols to communicate with the processor die 104 and route data on to and off of the HBM die stack 106. The interface logic 316 may employ protocols such as UCIe, HBM PHY, and any of the JEDEC-defined standards referred to above to ensure compatibility and performance. Within the HBM die stack 106, data is organized into channels, with each channel having multiple banks. Data access occurs via row and column commands, with the memory controller on the base die 320 issuing commands to open or close rows, read or write data, and refresh memory cells. The memory interface may use differential signaling and employ techniques like prefetching and burst transfers to maximize throughput. The base die 320 may include, e.g., speed testing circuitry, debugging circuitry, direct access circuity, configuration circuitry, backup memory in case of an error in a memory block of any of the memory dies 322, etc.

The HBM die stack 106 may have any suitable dimensions, such as a length and/or width of 5-15 millimeters and a height of 0.4-3 millimeters. In an illustrative embodiment, the HBM die stack 106 has a width (across the page from the perspective of FIG. 3) of about 7.7 millimeters and a length (into and out of the page from the perspective of FIG. 3) of about 11 millimeters. It should be appreciated that the interface logic 316 and microbumps 302 connected to the bridge die 212 extend into and out of the page, allowing for a large number of connections along the shoreline of the HBM die stack 106, improving bandwidth and signal quality. The width of the interface logic 316 and microbumps 302 connected to the bridge die 212 may be, e.g., 200-500 micrometers. In an illustrative embodiment, the width of the interface logic 316 is about 380 micrometers.

Each memory die 322 and/or base die 320 may have any suitable height, such as 15-200 micrometers. In an illustrative embodiment, part of the silicon substrate 304 of each die is removed as part of manufacturing the HBM die stack 106, leading to small die thicknesses. For example, the thickness of the silicon substrate 304 may be, e.g., 7 micrometers, and the layers 306 built up on the silicon substrate 304 may be, e.g., 8-11 micrometers. The pads 312 on the top and bottom of each die 320, 322 may have a thickness of, e.g., 3-6 micrometers. In some embodiments, the top die 322, 320 may not have its silicon substrate 304 removed (or as much removed), leading to a thicker top die 322, 320.

In an illustrative embodiment, as shown in FIG. 3, the base die 320 extends the full width of the HBM die stack 106, while the memory dies 322 do not. In particular, the memory dies 322 do not extend over the interface logic 316 of the base die 320. As the interface region is where all signals into and out of the HBM die stack 106 are routed and controlled, the interface logic 316 has one of or the highest power density dissipation of the HBM die stack 106, making the interface logic 316 a hot spot in the HBM die stack 106.

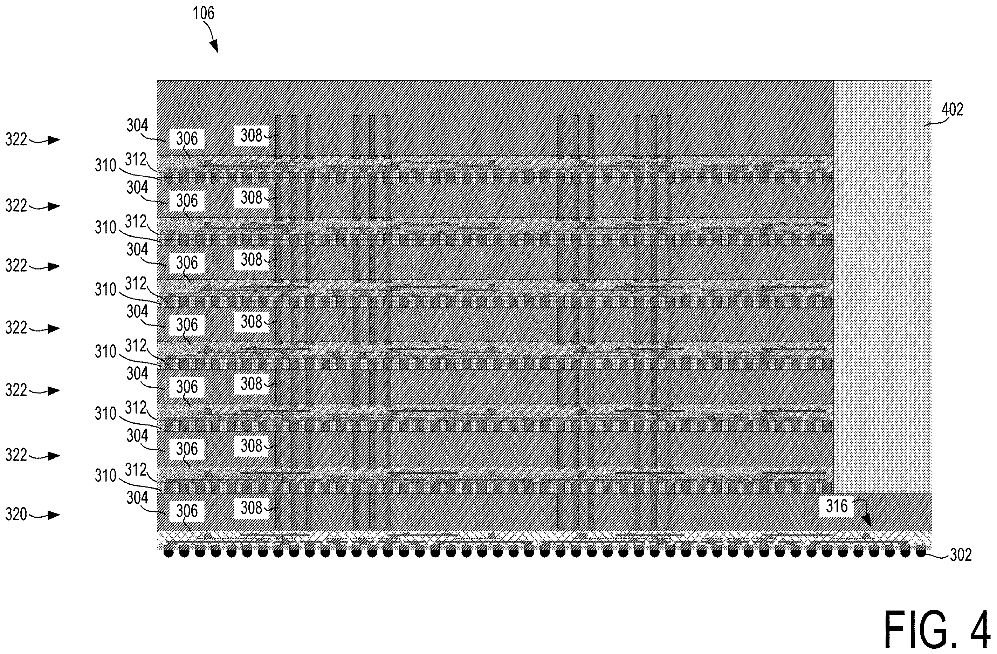

In order to remove heat from the hot spot of the interface logic 316, a stack 314 of one or more heat transfer layers is positioned above the interface logic 316. In an illustrative embodiment, as shown in FIG. 3, the stack 314 of one or more heat transfer layers may be embodied as a single-layer block, such as a block of structural silicon. In other embodiments, other materials may be used, such as silicon carbine, aluminum nitride, boron nitride, diamond, graphite, silicon oxide, silicon nitride, etc. In some embodiments, metals such as copper, silver, aluminum, etc., may be used. However, solid blocks of metal such as copper may be undesirable, due to a high mismatch of thermal conductivity with silicon, leading to possible stress. In some embodiments, the stack 314 of one or more heat transfer layers may include any suitable combination of the materials disclosed herein. Additional possible materials or combinations of materials are described below in more detail in regard to FIGS. 4-6. The material for the stack 314 of one or more heat transfer layers may have any suitable thermal conductivity, such as 125-2,200 Watts per meter-Kelvin. The stack 314 of one or more heat transfer layers may have any suitable coefficient of thermal expansion, such as 2.5-10 ppm/°C. The stack 314 may be bonded to the base die 320 in any suitable manner, such as using fusion bonding, anodic bonding, thermocompression bonding, adhesive bonding, plasma-assisted bonding, etc.

The stack 314 of one or more heat transfer layers may have any suitable dimensions, such as a width (across the page, from the perspective of FIG. 3) of, e.g., 0.1-1 millimeter, a length (into and out of the page, from the perspective of FIG. 4) of, e.g., 5-15 millimeters, and a height of, e.g., 0.3-2.5 millimeters. It should be appreciated that, in an illustrative embodiment, the stack 314 of one or more heat transfer layers extends into and out of the page along the entire shoreline of the HBM die stack 106, over the interface logic 316 extending along the entire shoreline. In one embodiment, the stack 314 of one or more heat transfer layers has a width of about 0.4 millimeters and a length of about 10 millimeters.

Referring now to FIG. 4, in one embodiment, the stack 314 of one or more heat transfer layers may be embodied as a layer 402 of dielectric packaging mold deposited on top of the interface logic 316, as shown in the figure. The layer 402 may be, e.g., polyimide, benzocyclobutene, epoxy, polymethyl methacrylate, silsesquioxanes, silicon oxide, silicon nitride, etc. In some embodiments, the layer 402 may include additives to increase the thermal conductivity, such as thermally-conductive particles of copper or diamond. The thermally-conductive particles may have any suitable thermal conductivity, such as 125-2,200 Watts per meter-Kelvin

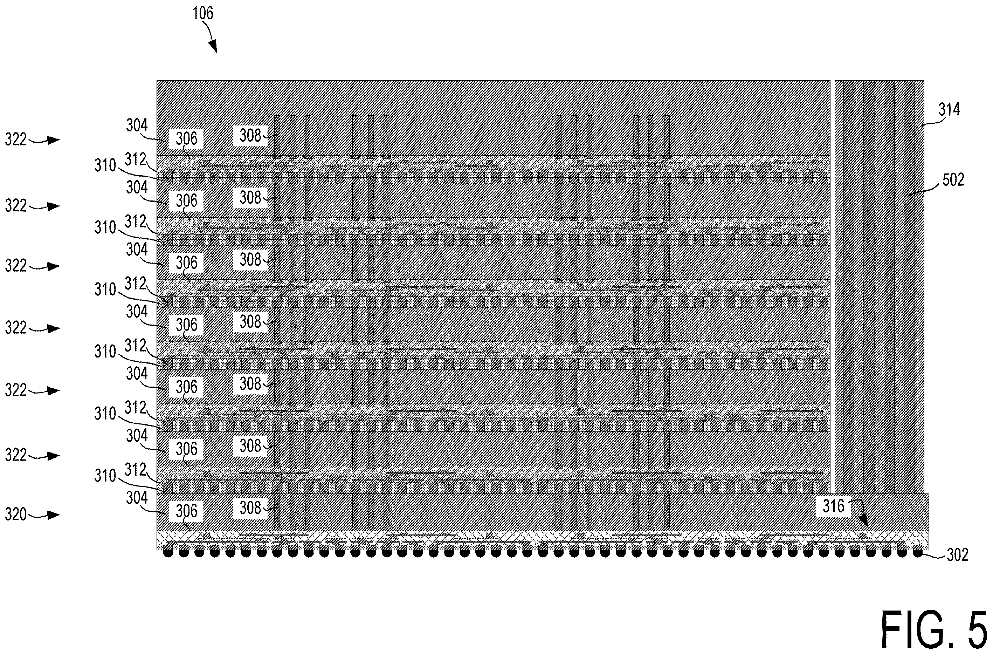

Referring now to FIG. 5, in one embodiment, the stack 314 of one or more heat transfer layers may be embodied as a silicon block with one or more vias 502 or pillars extending through the silicon block. The vias 502 may be filled with copper or other high-thermal-conductivity material. The vias 502 may have any suitable diameter, such as 50-300 micrometers. The vias 502 may have any suitable aspect ratio, such as 10:1-50:1. In some embodiments, different vias 502 may have different diameters, which may increase the fill factor for the higher-thermal-conductivity material in the vias 502. The vias 502 may have any suitable fill factor (i.e., percentage of the area of the stack 314 of one or more heat transfer layers from a top-down perspective), such as 5-50%. It should be appreciated that, in an illustrative embodiment, the vias 502 are not electrically connected to any component on the HBM die stack 106. Rather, the vias 502 are present for thermal conductivity.

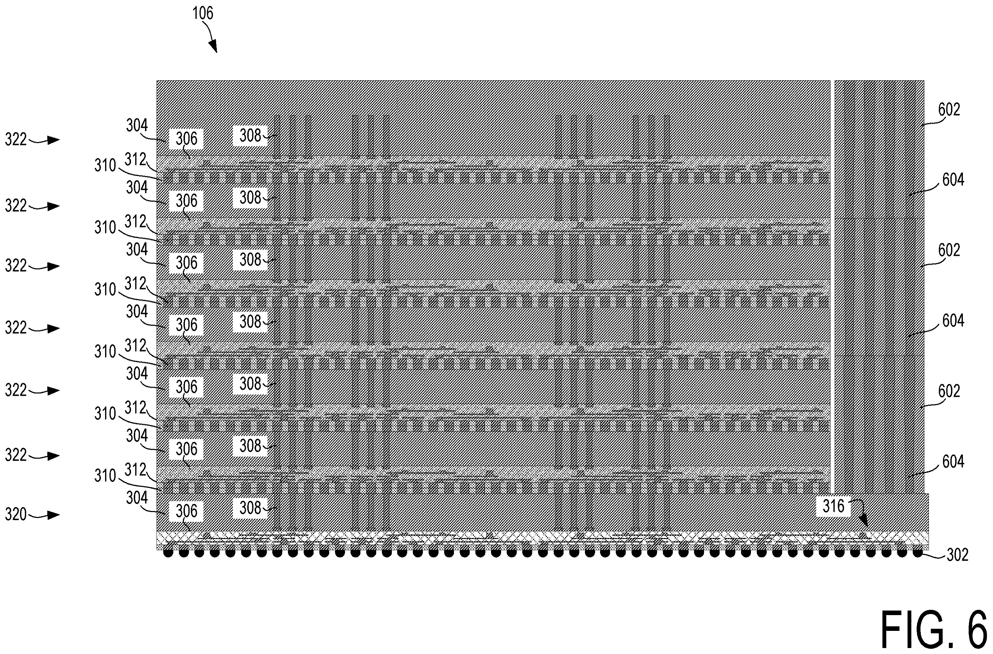

Referring now to FIG. 6, in one embodiment, the stack 314 of one or more heat transfer layers may include two or more silicon layers 602. The silicon layers 602 may have vias 604 defined within them. The vias 604 may be similar to the vias 502 described above. However, as the silicon layers 602 are not as thick as the silicon block shown in FIG. 5, the vias 604 can be a smaller diameter with the same aspect ratio as the vias 502 described above. For example, the vias 604 may have a diameter of, e.g., 10-300 micrometers. The stack of silicon layer 602 may include any suitable number of layers, such as 2-16. It should be appreciated that, in the illustrative embodiment, the silicon layers 602 are attached separately from the layers of silicon substrate 304 in the memory dies 322. In particular, there may be a different number of silicon layers 602 as memory dies 322, so the transitions between layers 602 may not be at the same height above the base die 320 as the transitions between memory dies 322.

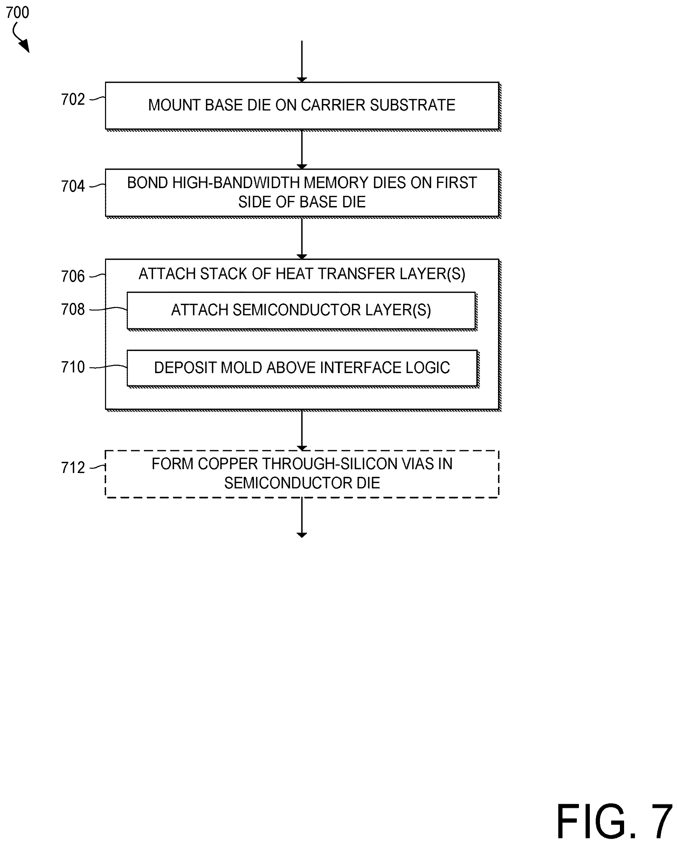

Referring now to FIG. 7, in one embodiment, a flowchart for a method 700 for creating the HBM die stacks 106 for the integrated circuit component 100 is shown. The method 700 may be executed by a technician and/or by one or more automated machines. In some embodiments, one or more machines may be programmed to do some or all of the steps of the method 700. Such a machine may include, e.g., a memory, a processor, data storage, etc. The memory and/or data storage may store instructions that, when executed by the machine, cause the machine to perform some or all of the steps of the method 700. The method 700 may use any suitable set of techniques that are used in semiconductor processing or circuit board processing, such as chemical vapor deposition, atomic layer deposition, physical layer deposition, molecular beam epitaxy, layer transfer, photolithography, ion implantation, dry etching, wet etching, selective laser etching, thermal treatments, flip chip, layer transfer, magnetron sputter deposition, pulsed laser deposition, laser machining, laser-induced deep etching, 3D photolithography, screen printing, ink jet printing, etc. It should be appreciated that the method 700 is merely one embodiment of a method to create one embodiment of a system, and other methods may be used to create any suitable embodiment of the system. In some embodiments, steps of the method 700 may be performed in a different order than that shown in the flowchart.

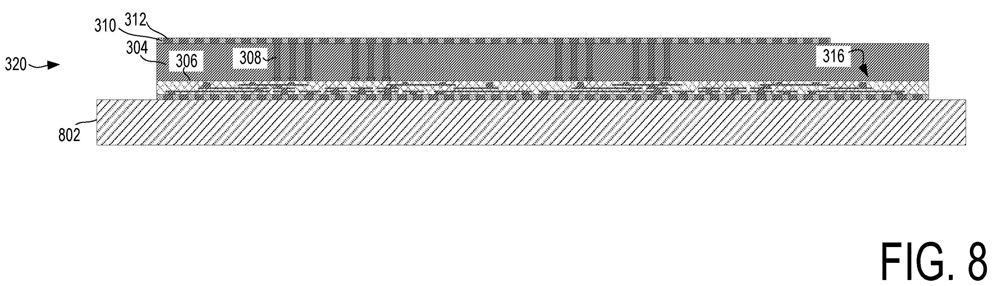

The method 700 begins in block 702, in which a base die 320 is mounted on a carrier substrate 802, as shown in FIG. 8. The carrier substrate 802 may be embodied as, e.g., silicon, silicon oxide, an organic substrate, etc. In an illustrative embodiment, backside processing may be performed on the base die 320 at this time. For example, the silicon substrate 304 may be ground down, holes for the TSVs 308 may be etched and filled, pads 312 may be applied, etc. In other embodiments, the base die 320 may be mounted with backside processing already complete.

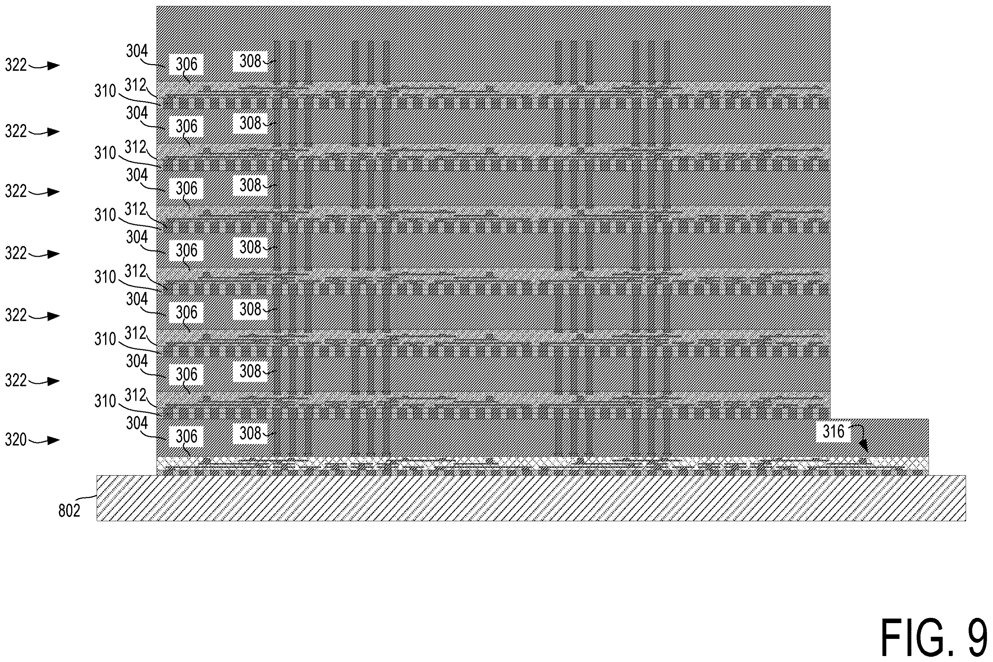

In block 704, one or more HBM memory dies 322 are mounted on the base die 320, as shown in FIG. 9. In an illustrative embodiment, each memory die 322 is mounted one at a time, and each memory die 322 may undergo back side processing, similar to the base die 320 described above. In other embodiments, the memory dies 322 may be mounted with backside processing already complete. In such embodiments, two or more memory dies 322 may be mounted at once. In an illustrative embodiment, the memory dies 322 are mounted on the base die 320 and/or other memory dies 322 using hybrid bonding. Additionally or alternatively, in other embodiments, other approaches may be used, such as solder bump bonding. It should be appreciated that, in some embodiments, the substrate 304 of the top memory die 322 may not be ground down.

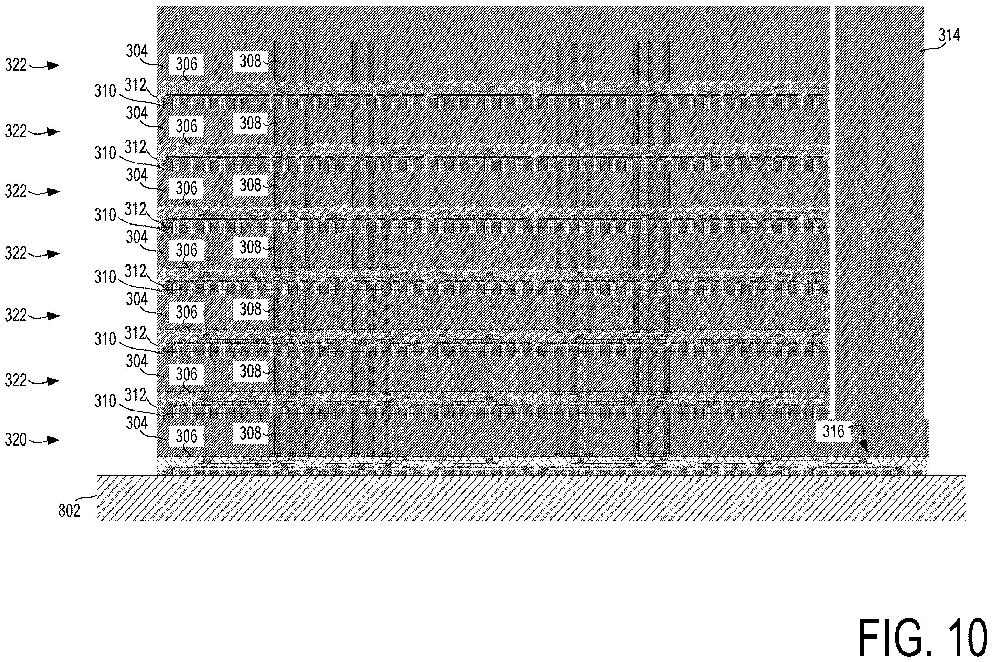

In block 706, the stack 314 of one or more heat transfer layers are attached to the base die 320 over the interface logic 316, as shown in FIG. 10. In one embodiment, one or more semiconductor layers are attached in block 708. Additionally or alternatively, in another embodiment, mold or other dielectric material is deposited above the interface logic 316 in block 710.

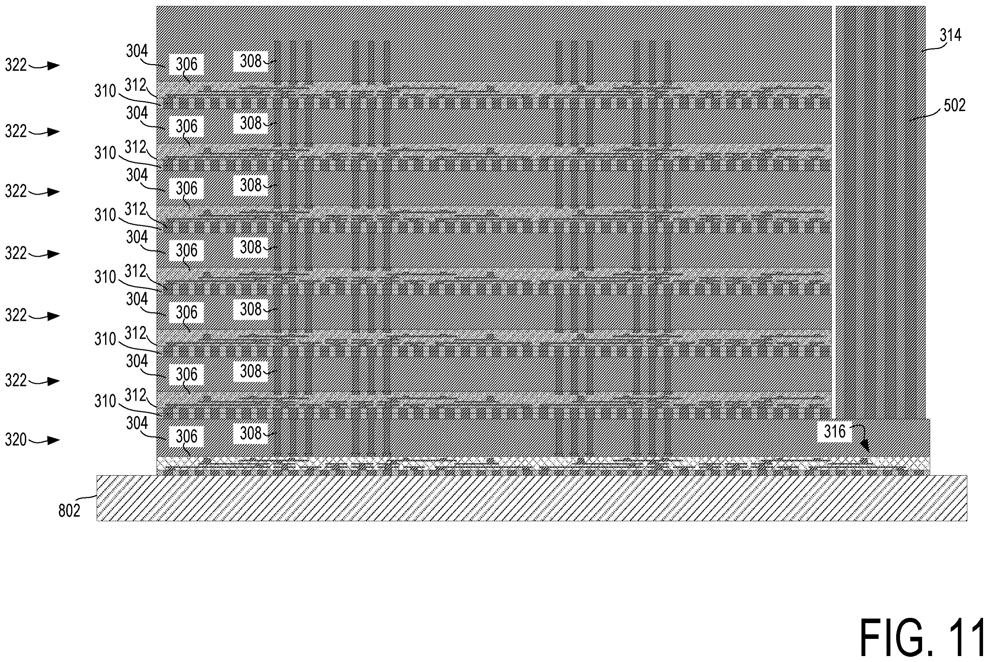

In block 712, in some embodiments, silicon vias 502 are formed in the semiconductor layer(s) mounted in block 708, as shown in FIG. 11. In embodiments in which multiple layers are mounted, vias 502 may be formed in each layer before the next layer is applied.

Processing of the HBM die stack 106 may then be continued, such as by forming microbumps on the base die 320, and then the HBM die stack 106 can be incorporated into another component, such as the integrated circuit component. A heat sink or integrated head spreader may be positioned on top of the HBM die stack 106, contacting both the top surface of the top memory die 322 as well as the stack 314 of one or more heat transfer layers.

It should be appreciated that, in the illustrative embodiment, the stack 314 of one or more heat transfer layers is incorporated into an HBM die stack 106, but the stack 314 of one or more heat transfer layers may be incorporated into other components in a similar manner, such as other components with multi-die stacks and/or components with a particular area at a lower level that acts as a hot spot.

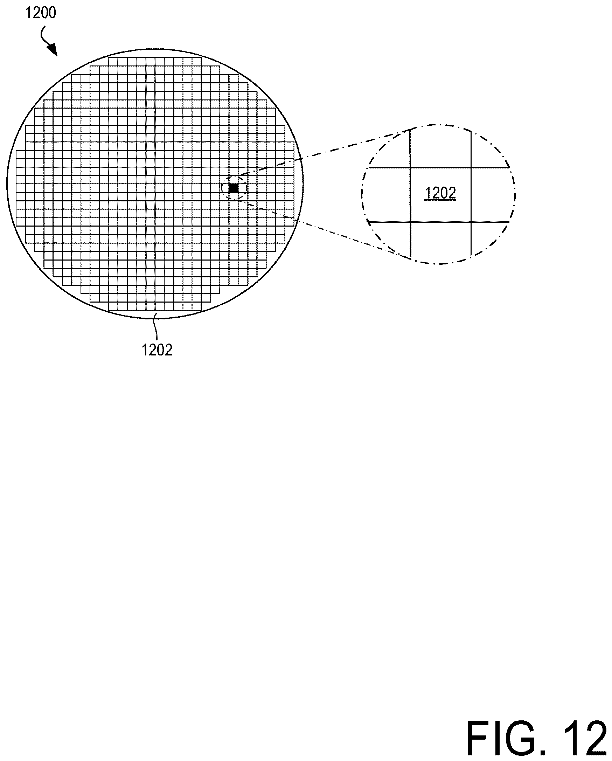

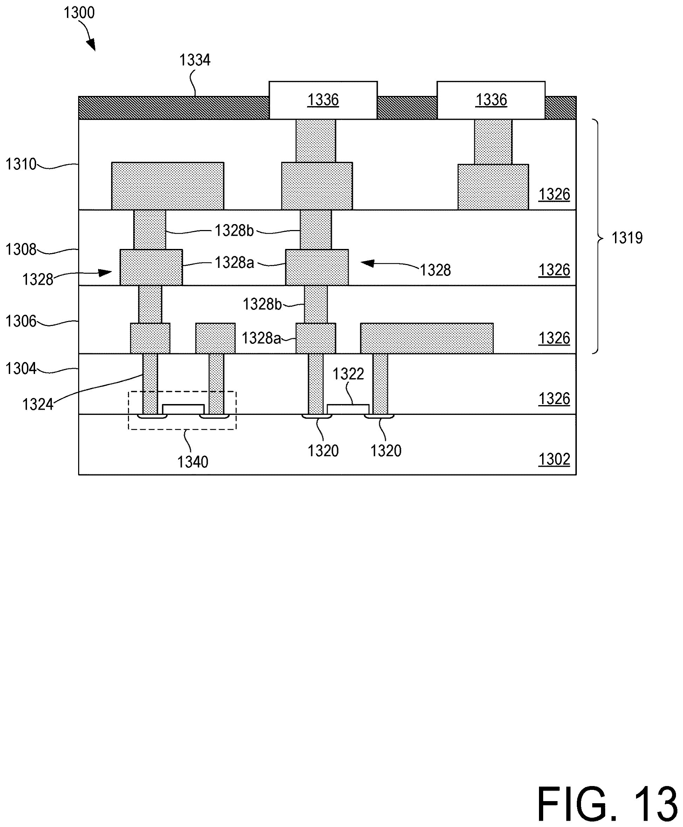

FIG. 12 is a top view of a wafer 1200 and dies 1202 that may be included in any of the integrated circuit components 100 disclosed herein (e.g., as any suitable ones of the dies 104, 320, 322). The wafer 1200 may be composed of semiconductor material and dies 1202 having integrated circuit structures formed on a surface of the wafer 1200. The individual dies 1202 may be a repeating unit of an integrated circuit product that includes any suitable integrated circuit. After the fabrication of the semiconductor product is complete, the wafer 1200 may undergo a singulation process in which the dies 1202 are separated from one another to provide discrete "chips" of the integrated circuit product. The dies 1202 may be any of the dies 104, 320, 322 disclosed herein. The dies 1202 may include one or more transistors (e.g., transistors 1340 of FIG. 13, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 1200 or the dies 1202 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array. Various ones of the integrated circuit components 100 disclosed herein may be manufactured using a die-to-wafer assembly technique in which some dies 104, 320, 322 are attached to a wafer 1200 that include others of the dies 104, 320, 322, and the wafer 1200 is subsequently singulated.

FIG. 13 is a cross-sectional view of an integrated circuit structure 1300 that may be included in any of the integrated circuit components 100 disclosed herein (e.g., in any of the dies 104, 320, 322). Multiple instances of the integrated circuit structure 1300 may be included in the dies 1202 (FIG. 12). The integrated circuit structure 1300 may be formed on a die substrate 1302. The die substrate 1302 may be a semiconductor substrate composed of semiconductor material including, for example, n-type or p-type materials (or a combination of both). The die substrate 1302 may include, for example, a crystalline substrate formed using a bulk silicon or a silicon-on-insulator (SOI) substructure. In some embodiments, the die substrate 1302 can comprise a layer of silicon on top of an SOI layer with bulk silicon below the SOI layer. In some embodiments, the die substrate 1302 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1302. Although a few examples of materials from which the die substrate 1302 may be formed are described here, any material that may serve as a foundation for an integrated circuit structure 1300 may be used. The die substrate 1302 may be part of a singulated die (e.g., dies 1202 of FIG. 12) or a wafer (e.g., wafer 1200 of FIG. 12).

The integrated circuit structure 1300 may include device layer 1304 disposed on the die substrate 1302. The device layer 1304 may include features of transistors 1340 (e.g., metal oxide semiconductor field-effect transistors (MOSFETs)) formed on the die substrate 1302. The transistors 1340 may include, for example, source and drain regions (S/D regions 1320), a gate 1322 to control current flow between the S/D regions 1320, and S/D contacts 1324 to route electrical signals to and from the S/D regions 1320. The transistors 1340 may include additional features not depicted for the sake of clarity, such as device isolation regions, gate contacts, and the like. The transistors 1340 are not limited to the type and configuration depicted in FIG. 13 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

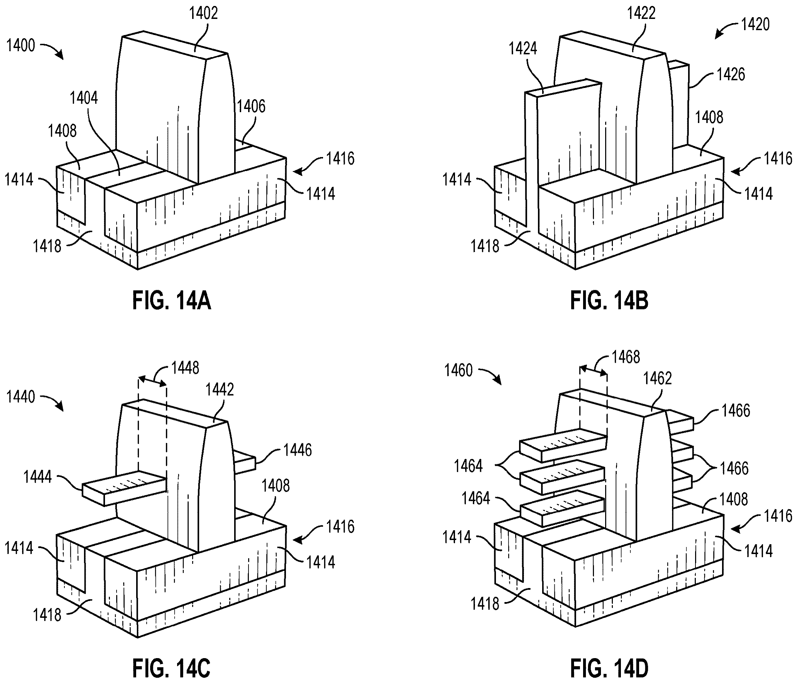

FIGS. 14A-14D are perspective views of example planar, FinFET, gate-all-around, and stacked gate-all-around transistors. The transistors illustrated in FIGS. 14A-14D are formed on a substrate 1416 having a substrate surface 1408 and a bulk region 1418. Isolation regions 1414 separate the source and drain regions of the transistors from other transistors.

FIG. 14A is a perspective view of an example transistor 1400 comprising a gate 1402 that controls current flow between a source region 1404 and a drain region 1406. The transistor 1400 is planar in that the source region 1404, the drain region 1406 and the substrate surface 1408 lie in the same plane.

FIG. 14B is a perspective view of an example transistor 1420 comprising a gate 1422 that controls current flow between a source region 1424 and a drain region 1426. The transistor 1420 is non-planar in that the source region 1424 and the drain region 1426 comprise "fins" that extend upwards from the substrate surface 1408. The transistor 1420 can be referred to as a FinFET. As the gate 1422 encompasses three sides of the fin that extends from the source region 1424 to the drain region 1426, the transistor 1420 can be considered a tri-gate transistor. FIG. 14B illustrates one S/D fin extending through the gate 1422, but multiple S/D fins can extend through the gate of a FinFET transistor.

FIG. 14C is a perspective view of a transistor 1440 comprising a gate 1442 that controls current flow between a source region 1444 and a drain region 1446. The transistor 1440 is non-planar in that the source region 1444 and the drain region 1446 lie in a different plane than the substrate surface 1408. As the gate 1442 encompasses all sides of the channel region of the transistor 1440 that extends from the source region 1444 to the drain region 1446, the transistor 1440 can be referred to as a gate-all-around (GAA) transistor.

FIG. 14D is a perspective view of a transistor 1460 comprising a gate 1462 that controls current flow between multiple elevated source regions 1464 and multiple elevated drain regions 1466. The transistor 1460 is a stacked GAA transistor as the gate controls the flow of current between multiple elevated S/D regions stacked on top of each other. The transistors 1440 and 1460 are considered gate-all-around transistors as the gates encompass all sides of the channel regions of the transistor that extends from the source regions to the drain regions. The transistors 1440 and 1460 can alternatively be referred to as nanowire, nanosheet, or nanoribbon transistors depending on the width (e.g., widths 1448 and 1468 of transistors 1440 and 1460, respectively) of the channel regions extending through the gate.

Returning to FIG. 13, transistors 1340 may include a gate 1322 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 14B, the gate electrode may have an upside-down U-shape that includes a top portion substantially parallel to the surface of the die substrate 1302 and two side portions that are substantially perpendicular to the top surface of the die substrate 1302. In other embodiments, such as the planar FET illustrated in FIG. 14A, at least one of the metal layers that form the gate electrode may be a planar layer that is substantially parallel to the top surface of the die substrate 1302 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 1320 may be formed within the die substrate 1302 adjacent to the gate 1322 of transistors 1340. The S/D regions 1320 may be formed using an implantation/diffusion process or an etching/deposition process, for example. In the former process, dopants such as boron, aluminum, antimony, phosphorous, or arsenic may be ion-implanted into the die substrate 1302 to form the S/D regions 1320. An annealing process that activates the dopants and causes them to diffuse further into the die substrate 1302 may follow the ion implantation process. In the latter process, the die substrate 1302 may first be etched to form recesses at the locations of the S/D regions 1320. An epitaxial deposition process may then be carried out to fill the recesses with material that is used to fabricate the S/D regions 1320. In some implementations, the S/D regions 1320 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1320 may be formed using one or more alternate semiconductor materials such as germanium or a group III-V material or alloy. In further embodiments, one or more layers of metal and/or metal alloys may be used to form the S/D regions 1320.

Electrical signals, such as power and/or information-carrying signals (e.g., input/output (I/O) signals, may be routed to and/or from devices (e.g., transistors 1340) of the device layer 1304 through one or more interconnect layers disposed on the device layer 1304 (illustrated in FIG. 13 as interconnect layers 1306-1310). For example, electrically conductive features of the device layer 1304 (e.g., the gate 1322 and the S/D contacts 1324) may be electrically coupled with interconnect structures 1328 of the interconnect layers 1306-1310. The one or more interconnect layers 1306-1310 may form a metallization stack 1319 (which can also be referred to as an "ILD stack" (inter-layer dielectric stack)) of the integrated circuit structure 1300.

The interconnect structures 1328 may be arranged within the interconnect layers 1306-1310 to route electrical signals according to a wide variety of designs; in particular, the arrangement is not limited to the particular configuration of interconnect structures 1328 depicted in FIG. 13. Although a particular number of interconnect layers 1306-1310 is depicted in FIG. 13, embodiments of the present disclosure include integrated circuit structures having more or fewer interconnect layers than depicted.

In some embodiments, the interconnect structures 1328 may include traces or lines 1328a and/or vias 1328b filled with an electrically conductive material such as a metal. The lines 1328a may be arranged to route electrical signals in a direction of a plane that is substantially parallel with a surface of the die substrate 1302 upon which the device layer 1304 is formed. For example, the lines 1328a may route electrical signals in a direction in and out of the page and/or in a direction across the page from the perspective of FIG. 13. The vias 1328b may be arranged to route electrical signals in a direction of a plane that is substantially perpendicular to the surface of the die substrate 1302 upon which the device layer 1304 is formed. In some embodiments, lines 1328a of different interconnect layers 1306-1310 are electrically coupled by vias 1328b.

The interconnect layers 1306-1310 may include a dielectric material 1326 within which the interconnect structures 1328 are disposed, as shown in FIG. 13. In some embodiments, dielectric material 1326 in different ones of the interconnect layers 1306-1310 may have different compositions; in other embodiments, the composition of the dielectric material 1326 between different interconnect layers 1306-1310 may be the same. The device layer 1304 may include a dielectric material 1326 within which the transistors 1340 are disposed and upon which a bottom layer of the metallization stack is located. The dielectric material 1326 that is part of the device layer 1304 may have a different composition than the dielectric material 1326 included in the interconnect layers 1306-1310; in other embodiments, the composition of the dielectric material 1326 in the device layer 1304 may be the same as a dielectric material 1326 included in any one of the interconnect layers 1306-1310.

A first interconnect layer 1306 (which can be referred to as a Metal 1 or "M1" layer) may be formed directly on the device layer 1304. In some embodiments, the first interconnect layer 1306 may include lines 1328a and/or vias 1328b, as shown. The lines 1328a of the first interconnect layer 1306 may be coupled with contacts (e.g., the S/D contacts 1324) of the device layer 1304. The vias 1328b of the first interconnect layer 1306 may be coupled with the lines 1328a of a second interconnect layer 1308.

The second interconnect layer 1308 (which can be referred to as a Metal 2 or "M2" layer) may be formed directly on the first interconnect layer 1306. In some embodiments, the second interconnect layer 1308 may include vias 1328b to couple the lines 1328a of the second interconnect layer 1308 with the lines 1328a of a third interconnect layer 1310. Although the lines 1328a and the vias 1328b are structurally delineated with a line within individual interconnect layers for the sake of clarity, the lines 1328a and the vias 1328b may be structurally and/or materially contiguous (e.g., simultaneously filled during a dual-damascene process) in some embodiments.

The third interconnect layer 1310 (which can be referred to as a Metal 3 or "M3" layer) (and additional interconnect layers, as desired) may be formed in succession on the second interconnect layer 1308 according to similar techniques and configurations described in connection with the second interconnect layer 1308 or the first interconnect layer 1306. In some embodiments, the interconnect layers that are "higher up" in the metallization stack 1319 in the integrated circuit structure 1300 (i.e., farther away from the device layer 1304) may be thicker than the interconnect layers that are lower in the metallization stack 1319, with lines 1328a and vias 1328b in the higher interconnect layers being thicker than those in the lower interconnect layers.

The integrated circuit structure 1300 may include a solder resist material 1334 (e.g., polyimide or similar material) and conductive contacts 1336 formed on the stack of interconnect layers 1306-1310. In FIG. 13, the conductive contacts 1336 are illustrated as taking the form of bond pads. The conductive contacts 1336 may be electrically coupled with interconnect structures 1328 of the top-most layer in the metallization stack 1319 and configured to route electrical signals between the transistors 1340 and components external to the integrated circuit structure 1300. For example, solder bonds may be formed on the conductive contacts 1336 to mechanically and/or electrically couple an integrated circuit component comprising the integrated circuit structure 1300 with another component (e.g., a printed circuit board). The integrated circuit structure 1300 may include additional or alternate structures to route electrical signals from the interconnect layers 1306-1310; for example, the conductive contacts 1336 may include other analogous features (e.g., posts) that can route the electrical signals between the transistors 1340 and external components. The conductive contacts 1336 may serve as the conductive contacts ### or ### , as appropriate.

In some embodiments in which the integrated circuit structure 1300 is part of a double-sided die (e.g., like the die ###), the integrated circuit structure 1300 may include a second metallization stack (not shown) located on the opposite side of the die substrate 1302 from the device layer 1304. This second metallization stack may include multiple interconnect layers as discussed above with reference to the interconnect layers 1306-1310. Through-silicon vias (TSVs) that extend through the die substrate 1302 can provide electrically conductive pathways from the transistors 1340 to the second metallization stack and the second metallizaton stack can electrically couple the TSVs to additional conductive contacts (not shown) located on the opposite side of the integrated circuit structure 1300 from the conductive contacts 1336. These additional conductive contacts may serve as the conductive pads 312, as appropriate.

In some embodiments, TSVs extending through the die substrate 1302 can be used for routing power and ground signals from conductive contacts located on the opposite side of the integrated circuit structure 1300 from the conductive contacts 1336 to the transistors 1340 and any other components integrated into the integrated circuit structure 1300, and the metallization stack 1319 can be used to route information-carrying signals from the conductive contacts 1336 to transistors 1340 and any other components integrated into the integrated circuit structure 1300. Put another way, the routing of power and ground signals to the transistors 1340 can be separated (via a back-side or bottom-side metallizaton stack and TSVs) from the routing of information-carrying signals to the transistors. The power and ground signals are provided by a backside or bottom-side metallization stack and TSVs, and information-carrying signals are provided by a topside metallization stack (e.g., metallization stack 1319).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

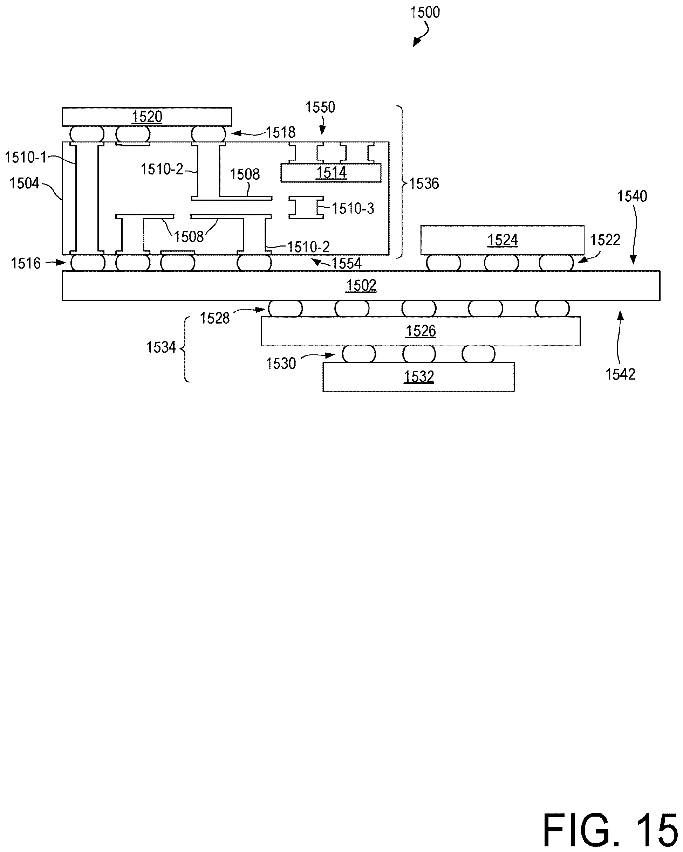

FIG. 15 is a cross-sectional view of an integrated circuit device assembly 1500 that may include any of the integrated circuit components 100 disclosed herein. In some embodiments, the integrated circuit device assembly 1500 may be an integrated circuit component 100. The integrated circuit device assembly 1500 includes a number of components disposed on a circuit board 1502 (which may be a motherboard, system board, mainboard, etc.). The integrated circuit device assembly 1500 includes components disposed on a first face 1540 of the circuit board 1502 and a second face 1542 of the circuit board 1502, the second face 1542 opposing the first face 1540. Generally, components may be disposed on either or both of the first face 1540 and the second face 1542 of the circuit board 1502. Any of the integrated circuit components discussed below with reference to the integrated circuit device assembly 1500 may take the form of any suitable ones of the embodiments of the integrated circuit components 100 disclosed herein.

In some embodiments, the circuit board 1502 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 1502. In other embodiments, the circuit board 1502 may be a non-PCB substrate. In some embodiments the circuit board 1502 may be, for example, the circuit board 102.

The integrated circuit device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502 and may include solder balls (as shown in FIG. 15), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.) The coupling components 1516 may serve as the coupling components illustrated or described for any substrate assembly or substrate assembly components described herein (e.g., integrated circuit components), as appropriate.

The package-on-interposer structure 1536 may include an integrated circuit component 1520 coupled to an interposer 1504. The interposer 1504 may provide an intervening substrate used to bridge the circuit board 1502 and the integrated circuit component 1520. The integrated circuit component 1520 is coupled to the interposer 1504 by coupling components 1518. The coupling components 1518 may take any suitable form, such as the forms discussed above with reference to the coupling components 1516. Although FIG. 15 shows just one integrated circuit component attached to the interposer, multiple integrated circuit components may be coupled to the interposer 1504. Additional interposers may be coupled to the interposer 1504.

The integrated circuit component 1520 may be a packaged or unpacked integrated circuit product that includes one or more integrated circuit dies (e.g., the die 1202 of FIG. 12, a die comprising the integrated circuit structure 1300 of FIG. 13) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 1520, a single monolithic integrated circuit die comprises solder bumps attached to contacts on the die. The solder bumps allow the die to be directly attached to the interposer 1504. The integrated circuit component 1520 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1520 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1520 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1520 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1504 may spread connections to a wider or narrower pitch or reroute a connection to a different connection. For example, the interposer 1504 may couple coupling components 1518 having a first pitch to coupling components 1516 having a wider pitch than the first pitch. In the embodiment illustrated in FIG. 15, the integrated circuit component 1520 and the circuit board 1502 are attached to opposing sides of the interposer 1504. In other embodiments, the integrated circuit component 1520 and the circuit board 1502 may be attached to a same side of the interposer 1504. In some embodiments, three or more components may be interconnected by way of the interposer 1504.

In some embodiments, the interposer 1504 may be formed as a PCB, including multiple metal layers separated from one another by layers of dielectric material and interconnected by electrically conductive vias. In some embodiments, the interposer 1504 may be formed of an epoxy resin, a fiberglass-reinforced epoxy resin, an epoxy resin with inorganic fillers, a ceramic material, or a polymer material such as polyimide. In some embodiments, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias, including but not limited to through hole vias 1510-1 (that extend from a first face 1550 of the interposer 1504 to a second face 1554 of the interposer 1504), blind vias 1510-2 (that extend from the first face 1550 or the second face 1554 of the interposer 1504 to an internal metal layer), and buried vias 1510-3 (that connect internal metal layers).

In some embodiments, the interposer 1504 can comprise a silicon interposer. Through silicon vias (TSV) extending through the silicon interposer can connect connections on a first face of a silicon interposer to an opposing second face of the silicon interposer. In some embodiments, an interposer 1504 comprising a silicon interposer can further comprise one or more routing layers to route connections on a first face of the interposer 1504 to an opposing second face of the interposer 1504.

In some embodiments the interposer 1504, as well as the circuit board 1502, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 1504 or circuit board 1502 to the glass layer. The glass layer can comprise through-glass vias (TGVs) that extend through the glass layer to provide electrically conductive paths through the glass core, glass substrate, or glass layer.

The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The integrated circuit device assembly 1500 may include an integrated circuit component 1524 coupled to the first face 1540 of the circuit board 1502 by coupling components 1522. The coupling components 1522 may take the form of any of the embodiments discussed above with reference to the coupling components 1516, and the integrated circuit component 1524 may take the form of any of the embodiments discussed above with reference to the integrated circuit component 1520.

The integrated circuit device assembly 1500 illustrated in FIG. 15 further includes a package-on-package structure 1534 coupled to the second face 1542 of the circuit board 1502 by coupling components 1528. The package-on-package structure 1534 may include an integrated circuit component 1526 and an integrated circuit component 1532 coupled together by coupling components 1530 such that the integrated circuit component 1526 is disposed between the circuit board 1502 and the integrated circuit component 1532. The coupling components 1528 and 1530 may take the form of any of the embodiments of the coupling components 1516 discussed above, and the integrated circuit components 1526 and 1532 may take the form of any of the embodiments of the integrated circuit component 1520 discussed above. The package-on-package structure 1534 may be configured in accordance with any of the package-on-package structures known in the art.

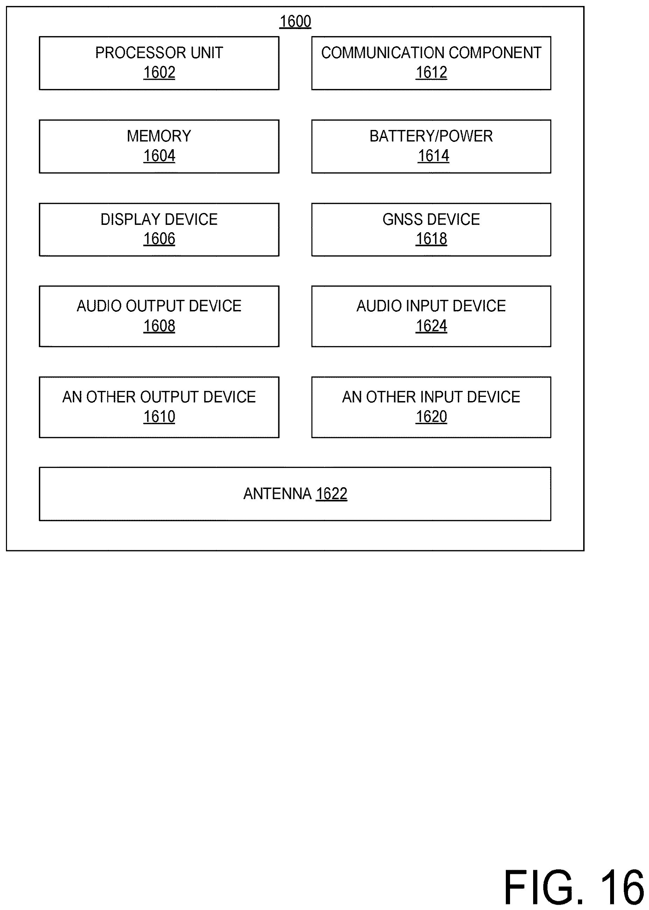

FIG. 16 is a block diagram of an example electrical device 1600 that may include any of the microelectronic assemblies disclosed herein. For example, any suitable ones of the components of the electrical device 1600 may include one or more of the integrated circuit device assembly 1500, integrated circuit component 1520, or integrated circuit structure 1300, integrated circuit dies 1202 disclosed herein, and may be arranged in any of the integrated circuit components 100 disclosed herein. A number of components are illustrated in FIG. 16 as included in the electrical device 1600, but any one or more of these components may be omitted or duplicated, as suitable for the application. In some embodiments, some or all of the components included in the electrical device 1600 may be attached to one or more motherboards mainboards, or system boards. In some embodiments, one or more of these components are fabricated onto a single system-on-a-chip (SoC) die.

Additionally, in various embodiments, the electrical device 1600 may not include one or more of the components illustrated in FIG. 16, but the electrical device 1600 may include interface circuitry for coupling to the one or more components. For example, the electrical device 1600 may not include a display device 1606, but may include display device interface circuitry (e.g., a connector and driver circuitry) to which a display device 1606 may be coupled. In another set of examples, the electrical device 1600 may not include an audio input device 1624 or an audio output device 1608, but may include audio input or output device interface circuitry (e.g., connectors and supporting circuitry) to which an audio input device 1624 or audio output device 1608 may be coupled.

The electrical device 1600 may include one or more processor units 1602. As used herein, the terms "processor unit," "processing unit," or "processor" may refer to any device or portion of a device that processes electronic data from registers and/or memory to transform that electronic data into other electronic data that may be stored in registers and/or memory. The one or more processor units 1602 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1600 may include a memory 1604, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1604 may include memory that is located on the same integrated circuit die as the one or more processor units 1602. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 1600, a first one of the one or more processor units 1602 can be heterogeneous or asymmetric to a second one of the one or more processor units 1602 in the electrical device 1600. There can be a variety of differences between the one or more processor units 1602 in a system in terms of a spectrum of metrics of merit including architectural, microarchitectural, thermal, power consumption characteristics, and the like. These differences can effectively manifest themselves as asymmetry and heterogeneity among the one or more processor units 1602 in the electrical device 1600.

In some embodiments, the electrical device 1600 may include a communication component 1612. For example, the communication component 1612 can manage wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1612 may operate in accordance with other wireless protocols in other embodiments. The electrical device 1600 may include an antenna 1622 to facilitate wireless communications and/or to receive other wireless communications (such as AM or FM radio transmissions).

In some embodiments, the communication component 1612 may manage wired communications, such as electrical, optical, or any other suitable communication protocols (e.g., IEEE 802.3 Ethernet standards). In some embodiments, the electrical device 1600 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display device 1606 (or corresponding interface circuitry, as discussed above). The display device 1606 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any embedded or wired or wirelessly connected external device that generates an audible indicator, such as speakers, headsets, or earbuds.

The electrical device 1600 may include an audio input device 1624 (or corresponding interface circuitry, as discussed above). The audio input device 1624 may include any embedded or wired or wirelessly connected device that generates a signal representative of a sound, such as microphones, microphone arrays, or digital instruments (e.g., instruments having a musical instrument digital interface (MIDI) output). The electrical device 1600 may include a Global Navigation Satellite System device (GNSS) (or corresponding interface circuitry, as discussed above), such as a Global Positioning System (GPS) device. The GNSS device 1618 may be in communication with a satellite-based system and may determine a geolocation of the electrical device 1600 based on information received from one or more GNSS satellites, as known in the art.

The electrical device 1600 may include another output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include another input device 1620 (or corresponding interface circuitry, as discussed above). Examples of the other input device 1620 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1600 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1600 may be any other electronic device that processes data. In some embodiments, the electrical device 1600 may comprise multiple discrete physical components. Given the range of devices that the electrical device 1600 can be manifested as in various embodiments, in some embodiments, the electrical device 1600 can be referred to as a computing device or a computing system.

### EXAMPLES

Illustrative examples of the technologies disclosed herein are provided below. An embodiment of the technologies may include any one or more, and any combination of, the examples described below.

Example 1 includes an apparatus comprising a semiconductor die stack comprising a base die comprising a top surface; a stack of one or more memory dies, the stack of one or more memory dies comprising a top surface and a bottom surface, wherein the bottom surface of the stack of one or more memory dies is adjacent to the top surface of the base die, wherein the top surface of the stack of one or more memory dies defines a plane; and a stack of one or more layers adjacent to the top surface of the base die, the stack of one or more layers to conduct heat from the base die, the stack of one or more layers extending from the top surface of the base die to at least the plane defined by the top surface of the stack of one or more memory dies.

Example 2 includes the subject matter of Example 1, and wherein the base die comprises interface logic to interface with a bridge die, wherein the stack of one or more layers is disposed above the interface logic of the base die.

Example 3 includes the subject matter of any of Examples 1 and 2, and wherein the stack of one or more layers comprises a layer comprising silicon.

Example 4 includes the subject matter of any of Examples 1-3, and further including one or more vias defined in the layer comprising silicon.

Example 5 includes the subject matter of any of Examples 1-4, and wherein the one or more vias extend to the base die, wherein the one or more vias are not connected to any signal trace on the base die.

Example 6 includes the subject matter of any of Examples 1-5, and wherein the stack of one or more layers comprises a plurality of layers, wherein individual layers of the plurality of layers comprise silicon.

Example 7 includes the subject matter of any of Examples 1-6, and further including one or more vias defined in individual layers of the plurality of layers.

Example 8 includes the subject matter of any of Examples 1-7, and wherein the stack of one or more layers comprises a layer comprising packaging mold.

Example 9 includes the subject matter of any of Examples 1-8, and wherein a plurality of thermally-conductive particles are disposed in the packaging mold, wherein the plurality of thermally-conductive particles have a thermal conductivity of at least 200 Watts per meter-Kelvin.

Example 10 includes the subject matter of any of Examples 1-9, and wherein the stack of one or more layers comprises a layer comprising silicon and oxygen.

Example 11 includes the subject matter of any of Examples 1-10, and wherein the stack of one or more layers is adjacent a heat sink or integrated heat spreader.

Example 12 includes the subject matter of any of Examples 1-11, and further including an integrated circuit component, the integrated circuit component comprising a circuit board, a processor die, a bridge die, and the semiconductor die stack, wherein the bridge die electrically couples the processor die and the semiconductor die stack.

Example 13 includes an apparatus comprising a semiconductor die stack comprising a base die comprising a top surface; a stack of one or more memory dies, the stack of one or more memory dies comprising a top surface and a bottom surface, wherein the bottom surface of the stack of one or more memory dies is adjacent to the top surface of the base die, wherein the top surface of the stack of one or more memory dies defines a plane; and stack of one or more heat transfer layers to transfer heat from the base die to at least the plane defined by the top surface of the stack of one or more memory dies.

Example 14 includes the subject matter of Example 13, and wherein the base die comprises interface logic to interface with a bridge die, wherein the stack of one or more heat transfer layers is disposed above the interface logic of the base die.

Example 15 includes the subject matter of any of Examples 13 and 14, and wherein the stack of one or more heat transfer layers comprises a layer comprising silicon.

Example 16 includes the subject matter of any of Examples 13-15, and further including one or more vias defined in the layer comprising silicon.

Example 17 includes the subject matter of any of Examples 13-16, and wherein the one or more vias extend to the base die, wherein the one or more vias are not connected to any signal trace on the base die.

Example 18 includes the subject matter of any of Examples 13-17, and wherein the stack of one or more heat transfer layers comprises a plurality of layers, wherein individual layers of the plurality of layers comprise silicon.

Example 19 includes the subject matter of any of Examples 13-18, and further including one or more vias defined in individual layers of the plurality of layers.

Example 20 includes the subject matter of any of Examples 13-19, and wherein the stack of one or more heat transfer layers comprises a layer comprising packaging mold.

Example 21 includes the subject matter of any of Examples 13-20, and wherein a plurality of thermally-conductive particles are disposed in the packaging mold, wherein the plurality of thermally-conductive particles have a thermal conductivity of at least 200 Watts per meter-Kelvin.

Example 22 includes the subject matter of any of Examples 13-21, and wherein the stack of one or more heat transfer layers comprises a layer comprising silicon and oxygen.

Example 23 includes the subject matter of any of Examples 13-22, and wherein the stack of one or more heat transfer layers is adjacent a heat sink or integrated heat spreader.

Example 24 includes the subject matter of any of Examples 13-23, and further including an integrated circuit component, the integrated circuit component comprising a circuit board, a processor die, a bridge die, and the semiconductor die stack, wherein the bridge die electrically couples the processor die and the semiconductor die stack.

Example 25 includes an apparatus comprising a semiconductor die stack comprising a base die comprising a top surface; a stack of one or more memory dies, the stack of one or more memory dies comprising a top surface and a bottom surface, wherein the bottom surface of the stack of one or more memory dies is adjacent to the top surface of the base die, wherein the top surface of the stack of one or more memory dies defines a plane; and a block, the block adjacent to the top surface of the base die, the block extending from the top surface of the base die to at least the plane defined by the top surface of the stack of one or more memory dies.

Example 26 includes the subject matter of Example 25, and wherein the base die comprises interface logic to interface with a bridge die, wherein the block is disposed above the interface logic of the base die.

Example 27 includes the subject matter of any of Examples 25 and 26, and wherein the block comprises silicon.

Example 28 includes the subject matter of any of Examples 25-27, and further including one or more vias defined in the block.

Example 29 includes the subject matter of any of Examples 25-28, and wherein the one or more vias extend to the base die, wherein the one or more vias are not connected to any signal trace on the base die.

Example 30 includes the subject matter of any of Examples 25-29, and wherein the block comprises packaging mold.

Example 31 includes the subject matter of any of Examples 25-30, and wherein a plurality of thermally-conductive particles are disposed in the packaging mold, wherein the plurality of thermally-conductive particles have a thermal conductivity of at least 200 Watts per meter-Kelvin.

Example 32 includes the subject matter of any of Examples 25-31, and wherein the block comprises silicon and oxygen.

Example 33 includes the subject matter of any of Examples 25-32, and wherein the block is adjacent a heat sink or integrated heat spreader.

Example 34 includes the subject matter of any of Examples 25-33, and further including an integrated circuit component, the integrated circuit component comprising a circuit board, a processor die, a bridge die, and the semiconductor die stack, wherein the bridge die electrically couples the processor die and the semiconductor die stack.

Example 35 includes a method for forming a high-bandwidth memory die stack comprising bonding a plurality of high-bandwidth memory dies on a top side of a base die; and attaching a stack of heat transfer layers on the top side of the base die.

Example 36 includes the subject matter of Example 35, and wherein bonding the plurality of high-bandwidth memory dies comprises mounting the base die on a carrier substrate; and bonding the plurality of high-bandwidth memory dies while the base die is attached to the carrier substrate.

Example 37 includes the subject matter of any of Examples 35 and 36, and wherein attaching the stack of heat transfer layers comprises attaching a semiconductor die on the top side of the base die.

Example 38 includes the subject matter of any of Examples 35-37, and further including etching a plurality of holes in the semiconductor die and filling the plurality of holes to form vias in the semiconductor die.

Example 39 includes the subject matter of any of Examples 35-38, and wherein attaching the stack of heat transfer layers comprises attaching a plurality of semiconductor dies on the top side of the base die.

Example 40 includes the subject matter of any of Examples 35-39, and further including etching a plurality of holes in individual semiconductor dies of the plurality of semiconductor dies and filling the plurality of holes in individual semiconductor dies of the plurality of semiconductor dies to form vias in individual semiconductor dies of the plurality of semiconductor dies.

Example 41 includes the subject matter of any of Examples 35-40, and wherein attaching the stack of heat transfer layers comprises depositing packaging mold over the base die.

## Claims

1. An apparatus comprising:
a semiconductor die stack comprising:
a base die comprising a top surface;
a stack of one or more memory dies, the stack of one or more memory dies comprising a top surface and a bottom surface, wherein the bottom surface of the stack of one or more memory dies is adjacent to the top surface of the base die, wherein the top surface of the stack of one or more memory dies defines a plane; and
a stack of one or more layers adjacent to the top surface of the base die, the stack of one or more layers to conduct heat from the base die, the stack of one or more layers extending from the top surface of the base die to at least the plane defined by the top surface of the stack of one or more memory dies.

2. The apparatus of claim 1, wherein the base die comprises interface logic to interface with a bridge die, wherein the stack of one or more layers is disposed above the interface logic of the base die.

3. The apparatus of any one of claims 1-2, wherein the stack of one or more layers comprises a layer comprising silicon.

4. The apparatus of claim 3, further comprising one or more vias defined in the layer comprising silicon.

5. The apparatus of claim 4, wherein the one or more vias extend to the base die, wherein the one or more vias are not connected to any signal trace on the base die.

6. The apparatus of any one of claims 1-5, wherein the stack of one or more layers comprises a plurality of layers, wherein individual layers of the plurality of layers comprise silicon.

7. The apparatus of claim 6, further comprising one or more vias defined in individual layers of the plurality of layers.

8. The apparatus of any one of claims 1-7, wherein the stack of one or more layers comprises a layer comprising packaging mold.

9. The apparatus of claim 8, wherein a plurality of thermally-conductive particles are disposed in the packaging mold, wherein the plurality of thermally-conductive particles have a thermal conductivity of at least 200 Watts per meter-Kelvin.

10. The apparatus of any one of claims 1-9, wherein the stack of one or more layers comprises a layer comprising silicon and oxygen.

11. The apparatus of any one of claims 1-10, wherein the stack of one or more layers is adjacent a heat sink or integrated heat spreader.

12. The apparatus of any one of claims 1-11, further comprising an integrated circuit component, the integrated circuit component comprising a circuit board, a processor die, a bridge die, and the semiconductor die stack, wherein the bridge die electrically couples the processor die and the semiconductor die stack.

13. A method for forming a high-bandwidth memory die stack comprising:
bonding a plurality of high-bandwidth memory dies on a top side of a base die; and
attaching a stack of heat transfer layers on the top side of the base die.

14. The method of claim 13, wherein bonding the plurality of high-bandwidth memory dies comprises:
mounting the base die on a carrier substrate; and
bonding the plurality of high-bandwidth memory dies while the base die is attached to the carrier substrate.

15. The method of any of claims 13-14, wherein attaching the stack of heat transfer layers comprises attaching a semiconductor die on the top side of the base die.
